# EUROPEAN PATENT SPECIFICATION

(11) **EP 4 270 790 B1**
(45) Date of publication and mention of the grant of the patent: **28.10.2026**
(21) Application number: 23169707.9
(22) Date of filing: 25.04.2023
(51) Int. Cl.: H03K 17/96

(54) **CAPACITIVE SENSOR DEVICE WITH DRIFT COMPENSATION**
KAPAZITIVE SENSORVORRICHTUNG MIT DRIFTKOMPENSATION
DISPOSITIF DE CAPTEUR CAPACITIF À COMPENSATION DE DÉRIVE

(30) Priority: 27.04.2022 US 202263335508 P
(43) Date of publication of application: 01.11.2023
(73) Proprietor: Semtech Corporation, Camarillo CA 93012-8790 (US)
(72) Inventor: Rouaissia, Chaouki, 2000 Neuchâtel (CH); Grisot, Sébastien, 2017 Boudry (CH); Ott III, Jerald George, Escondido CA, 92025 (US)
(74) Representative: P&TS SA (AG, Ltd.)

(56) References cited:
- EP-A1- 3 751 397
- US-A1- 2008 047 764
- US-A1- 2014 354 582

## Description

### Field of the invention

The present invention relates to a capacitive sensor device and to a portable electronic device comprising the capacitive sensor device.

### Background to the invention

Proximity awareness is a requirement in most recent smartphones and connected personal devices, where it is used to limit radiation dose, to prevent accidental inputs on a touch display, to dim a backlit panel, and in many other cases. Document EP3796140 discloses a capacitive sensor device that can be used among others to detect proximity of a user's body part in a portable phone, a tablet, or a similar portable electronic device.

Capacitance measured by a capacitive sensor device is typically subject to drift due to environmental influences, e.g., changing temperature or humidity. Changing environmental influences typically change physical properties of at least parts of the portable electronic device and of the capacitive sensor device by, e.g., changing thicknesses or permittivity of materials, thereby changing measured capacitances. Based on such altered capacitance measurements due to environmentally caused drift, the capacitive sensor device may determine faulty proximity signals.

It is an object of the present invention to mitigate at least some of the disadvantages associated with capacitive sensor devices known from the state of the art.
EP 3751397 A1 discloses a proximity detector with a drift simulation unit generating a corrective signal that is subtracted from a detection signal. US 2008/0047764 A1 a touch-sensing device compensating for an environmental effect.

### Summary of the invention

According to a first aspect of the present invention there is provided a capacitive sensor device involving the features recited in claim 1. Further optional features and embodiments of the capacitive sensor device are described in the dependent patent claims.

The invention relates to a capacitive sensor device comprising a capacitance-measuring circuit, a main sense input and a reference sense input, wherein the capacitive sensor device is configured to measure, using the capacitance-measuring circuit, a current main value of capacitance seen by the main sense input and a current reference value of capacitance seen by the reference sense input, wherein the capacitive sensor device is configured to at least temporarily store at least one previously measured reference value, and wherein the capacitive sensor device is configured to use 1) the current main value, 2) the current reference value and the at least one previously measured reference value, and 3) at least one current correction coefficient, with the capacitive sensor device being configured to adaptively determine the at least one current correction coefficient based on at least the current reference value and the at least one previously measured reference value, for determining a corrected current main value of capacitance.

The correcting of measured main values on the capacitive sensor device may be carried out in real time. Whenever a new current main value is measured, correction may be carried out. The capacitance seen by the reference sense input may be substantially only sensitive to environmental drifts, e.g., temperature changes in the vicinity of the capacitive sensor device, and the capacitance seen by the main sense input may be sensitive to both environmental drifts, e.g., aforementioned temperature changes, and to approaching/receding conductive bodies, e.g., embodied as human bodies. The current main value *MV*(*tₙ*) may be sampled by the capacitance-measuring circuit at a time *tₙ*, and the current reference value may also be sampled at the time *tₙ* or at a different time. Main values and reference values need not be sampled at the same sampling times. Previously measured reference values may have been sampled at times *t*_{*n*-1}, *t*_{*n-*2}, ... by the capacitance-measuring circuit. The following reference values may therefore be sampled and available for further processing: *RV*(*tₙ*),*RV*(*t*_{*n-*1})*,RV*(*t*_{*n*-2}), ..., potentially back to a first acquired capacitance measurement *RV*(*t*₀) at a first sampling time *t*₀.

In an embodiment of the capacitive sensor device according to the invention, the capacitive sensor device is configured to adaptively determine the at least one current correction coefficient by adaptively selecting, based on a selection criterion based on the current reference value and the at least one previously measured reference value, the at least one current correction coefficient from at least two predetermined correction coefficients, and wherein the selection criterion comprises a comparison to at least one threshold.

The at least two predetermined correction coefficients may be stored on the capacitive sensor device. The at least two predetermined correction coefficients may be determined in a calibration process. The at least two predetermined correction coefficients may correspond to different operating conditions. In case the at least two predetermined correction coefficients comprise, e.g., only two predetermined correction coefficients, a first of the two predetermined correction coefficients may correspond to an operating condition of rising temperature, while a second of the two predetermined correction coefficients may correspond to an operating condition of falling temperature. In general, the capacitive sensor device may use the measured reference values to determine which operating condition is currently applicable and select as the at least one current correction coefficient predetermined correction coefficient(s) from the at least two predetermined correction coefficients corresponding to the determined operating condition. The just-described principle for determining the least one current correction coefficient may also be applicable to other physical reasons - besides temperature changes - causing different operating conditions in which different correction coefficients may be needed to optimally correct environmental drift in the main values. Selecting correction coefficients may be based on comparison operations with respect to at least one threshold.

In a further embodiment of the capacitive sensor device according to the invention, the capacitive sensor device is configured to determine a current difference reference value between the current reference value and a comparison reference value from the at least one previously measured reference value, and the comparison comprises comparing the current difference reference value to the at least one threshold.

A current difference reference value may be determined by the following operation: Δ*RV*(*tₙ*) *= RV*(*tₙ*) *- RV*(*t*_{*n-*1}). A current difference reference value may, however, also be determined as follows: Δ*RV*(*tₙ*) *= RV*(*tₙ*) *- RV*(*tₙ₋ₘ*), with m greater than one. This way, samples of reference values which were determined earlier than the last previously (previous referring to the current sampling time *tₙ*) acquired sample at time *t*_{*n*-1} may be used for determining a current difference reference value. The current difference reference value may be compared to at least one threshold: based on such a comparison, it may be determined which operating condition is currently applicable and which at least one current correction coefficient should be selected from the at least two predetermined correction coefficients, for example. A threshold of zero may be used to measure whether the reference value is increasing or decreasing. In case an increasing environmental temperature in the vicinity of the capacitive sensor device leads to an increasing reference value and a decreasing temperature leads to a decreasing reference value, a threshold of zero may be used to determine if environmental temperature is increasing or decreasing, for example.

In a further embodiment of the capacitive sensor device according to the invention, the at least two predetermined correction coefficients comprise a first first order correction coefficient and a second first order correction coefficient which differ from one another and wherein a single current correction coefficient is adaptively selected from the first first order correction coefficient and the second first order correction coefficient, wherein the at least one threshold comprises a single threshold, and wherein the capacitive sensor device is configured to determine whether the current difference reference value is larger or smaller than the single threshold, wherein for a larger current difference reference value the first first order correction coefficient is selected as the single current correction coefficient and for a smaller current difference reference value the second first order correction coefficient is selected as the single current correction coefficient, and wherein the capacitive sensor device is configured to determine the corrected current main value by subtracting the product of the single current correction coefficient and a cumulated difference reference value from the current main value.

Environmentally caused drift may be removed from the current main value using a first-order linear correction in which only a single current correction coefficient is used. The single threshold *TS* may be compared to the current difference reference value Δ*RV*(*tₙ*): if Δ*RV*(*tₙ*) *> TS,* the first first order correction coefficient *C*_{1;1} may be selected as the single current correction coefficient *Cₙ*, and if Δ*RV*(*tₙ*) < *TS,* the second first order correction coefficient *C*_{2;1} may be selected as the single current correction coefficient *Cₙ*. In case Δ*RV*(*tₙ*) = *TS, C*_{1;1} or *C*_{2;1} may be selected. After selecting the single current correction coefficient *Cₙ* as just described, the corrected current main value *MV**(*tₙ*) may be determined as follows: *MV**(*tₙ*) *= MV*(*tₙ*) *- Cₙ*Δ*RV*⁽⁰⁾(*tₙ*), with Δ*RV*⁽⁰⁾(*tₙ*) being the cumulated difference reference value defined as Δ*RV*⁽⁰⁾(*tₙ*) *= RV*(*tₙ*) *- RV*(*t*₀)*.* The single threshold may be assigned a value of zero. The first first order correction coefficient may correspond to rising temperature, and the second first order correction coefficient may correspond to falling temperature.

In a further embodiment of the capacitive sensor device according to the invention, the at least two predetermined correction coefficients comprise a first first order correction coefficient and a second first order correction coefficient which differ from one another and wherein a single current correction coefficient is adaptively selected from the first first order correction coefficient and the second first order correction coefficient, wherein the capacitive sensor device is configured to at least temporarily store at least one previously determined difference reference value, and wherein the capacitive sensor device is configured to determine a filtered current difference reference value by applying a filter to the current difference reference value and the at least one stored previously determined difference reference value, wherein the at least one threshold comprises a single threshold, and wherein the capacitive sensor device is configured to determine whether the filtered current difference reference value is larger or smaller than the single threshold, wherein for a larger filtered current difference reference value the first first order correction coefficient is selected as the single current correction coefficient and for a smaller current difference reference value the second first order correction coefficient is selected as the single current correction coefficient, and wherein the capacitive sensor device is configured to determine the corrected current main value by subtracting the product of the single current correction coefficient and a cumulated difference reference value from the current main value.

For a new reference value sampled at time *tₙ*, *RV*(*tₙ*)*,* the current difference reference value Δ*RV*(*tₙ*) may be determined. The capacitive sensor device may also store previously determined difference reference values, e.g., previously determined difference reference value Δ*RV*(*t*_{*n*-1}) = *RV*(*t*_{*n*-1}) *- RV*(*t*_{*n-*2}), Δ*RV*(*t*_{*n*-2}), and so on. The current difference reference value and at least one previously determined difference reference value may, for example, be stored in a fixed-size buffer. The fixed-size buffer may, for example, be set up in such a way that it can store *l* different difference reference values. Before the current difference reference value Δ*RV*(*tₙ*) is stored in the fixed-size buffer, the fixed-size buffer may comprise, for example, the following difference reference values: Δ*RV*(*tₙ₋ₗ*)*, ... ,* Δ*RV*(*t*_{*n-*1}). To store Δ*RV*(*tₙ*) in the fixed-size buffer, Δ*RV*(*tₙ₋ₗ*) may be removed, providing the following difference reference values in the fixed-size buffer: Δ*RV*(*t*_{*n-l*+1}), *...,*Δ*RV*(*tₙ*). A causal finite impulse response (FIR) filter, e.g., providing smoothing/averaging, may operate on the elements in the fixed-size buffer to provide a filtered current difference reference value ${Δ RV}^{˜} \left({t}_{n}\right)$, and this filtered current difference reference value may be compared to a single threshold *TS* stored on the capacitive sensor device: if ${Δ RV}^{˜} \left({t}_{n}\right) > TS$*,* a first first order correction coefficient *C*_{1;1} may be selected as the current correction coefficient *Cₙ*, and if ${Δ RV}^{˜} \left({t}_{n}\right) < TS$, a second first order correction coefficient *C*_{2;2} may be selected as the current correction coefficient *Cₙ*. In case ${Δ RV}^{˜} \left({t}_{n}\right) = TS$*, C*_{1;1} or *C*_{2;1} may be selected. After selecting the single current correction coefficient *Cₙ* as just described, the corrected current main value *MV**(*tₙ*) may be determined as follows: *MV**(*tₙ*) *= MV*(*tₙ*) *- Cₙ*Δ*RV*⁽⁰⁾(*tₙ*), with Δ*RV*⁽⁰⁾(*tₙ*) being the cumulated difference reference value defined as Δ*RV*⁽⁰⁾(*tₙ*) *= RV*(*tₙ*) *- RV*(*t*₀)*.* The single threshold may be assigned a value of zero. The first first order correction coefficient may correspond to rising temperature, and the second first order correction coefficient may correspond to falling temperature. Depending on the size of *l*, the number of entries in the fixed-size buffer, and the FIR filter employed, ${Δ RV}^{˜} \left({t}_{n}\right)$ may correspond to an average direction, i.e., a slope/trend, of the reference values close to the current reference value *RV*(*tₙ*)*.* In case a delay is acceptable, the FIR filter may also be noncausal.

In a further embodiment of the capacitive sensor device according to the invention, the at least two predetermined correction coefficients comprise a first first order correction coefficient, a second first order correction coefficient, a first second order correction coefficient and a second second order correction coefficient, wherein two current correction coefficients are adaptively selected from these four predetermined correction coefficients, wherein the at least one threshold comprises a single threshold, and wherein the capacitive sensor device is configured to determine whether the current difference reference value is larger or smaller than the single threshold, wherein for a larger current difference reference value the first first order correction coefficient is selected as a first current correction coefficient of the two current correction coefficients and the first second order correction coefficient is selected as a second current correction coefficient of the two current correction coefficients, and wherein for a smaller current difference reference value the second first order correction coefficient is selected as a first current correction coefficient of the two current correction coefficients and the second second order correction coefficient is selected as a second current correction coefficient of the two current correction coefficients, and wherein the capacitive sensor device is configured to determine the corrected current main value by subtracting the product of the first current correction coefficient and a cumulated difference reference value and the product of the second current correction coefficient with the square of the cumulated difference reference value from the current main value.

The first first order correction coefficient *C*_{1;1}, the second first order correction coefficient *C*_{2;1}, the first second order correction coefficient *C*_{1;2} and the second second order correction coefficient *C*_{2;2} may be stored on the capacitive sensor device and obtained in a calibration procedure. The capacitive sensor device may correct the current main value *MV*(*tₙ*) based on a first current correction coefficient, wherein the value assigned to the first current correction coefficient may be adaptively selected as the first first order correction coefficient or as the second first order correction coefficient, and a second current correction coefficient, wherein the value assigned to the second current correction coefficient may be adaptively selected as the first second order correction coefficient or as the second second order correction coefficient. The single threshold *TS* may be compared to the current difference reference value Δ*RV*(*tₙ*): if Δ*RV*(*tₙ*) *> TS,* the first first order correction coefficient *C*_{1;1} may be selected as the first current correction coefficient ${C}_{n}^{\left(1\right)}$ and the first second order correction coefficient *C*_{1;2} may be selected as the second current correction coefficient ${C}_{n}^{\left(2\right)}$, and if Δ*RV*(*tₙ*) < *TS,* the second first order correction coefficient *C*_{2;1} may be selected as the first current correction coefficient ${C}_{n}^{\left(1\right)}$ and the second second order correction coefficient *C*_{2;2} may be selected as the second current correction coefficient ${C}_{n}^{\left(2\right)}$. For Δ*RV*(*tₙ*) = *TS,* it may be arbitrary which of the predetermined correction coefficients is assigned to the two current correction coefficients. The corrected current main value *MV**(*tₙ*) may be determined as follows: $MV * \left({t}_{n}\right) = MV \left({t}_{n}\right) - {C}_{n}^{\left(1\right)} Δ {RV}^{\left(0\right)} \left({t}_{n}\right) - {C}_{n}^{\left(2\right)} {\left(Δ{RV}^{\left(0\right)}\left({t}_{n}\right)\right)}^{2}$ , with Δ*RV*⁽⁰⁾(*tₙ*) being the cumulated difference reference value defined as Δ*RV*⁽⁰⁾(*tₙ*) = *RV*(*tₙ*) *- RV*(*t*₀)*.* The single threshold may be assigned a value of zero. The just-described correction corrects therefore both first-order components and second-order drift components in the main values. This may be particularly beneficial in case the relationship/ratio between main values and reference values is far away from a first order relationship, and this may in particular be influenced by the hardware implementation of the capacitive sensor device, specifically by the presence of discrete components and by the location of heat sources etc.

In a further embodiment of the capacitive sensor device according to the invention, the at least one threshold comprises a first threshold and a second threshold, wherein the first threshold is smaller than the second threshold, and wherein the at least two predetermined correction coefficients comprise a first correction coefficient, a second correction coefficient and a third correction coefficient, wherein a single current correction coefficient is adaptively selected from these three predetermined correction coefficients, and wherein the capacitive sensor device is configured to select 1) the first correction coefficient as the single current correction coefficient if a cumulated difference reference value is smaller than the first threshold, 2) the second correction coefficient as the single current correction coefficient if the cumulated difference reference value is larger than or equal to the first threshold and smaller than or equal to the second threshold, and 3) the third correction coefficient as the single current correction coefficient if the cumulated difference reference value is larger than the second threshold, and wherein the capacitive sensor device is configured to determine the corrected current main value by subtracting the product of the single current correction coefficient and the cumulated difference reference value from the current main value.

In general, the at least one threshold may comprise *k* thresholds *TS*₁*, TS₂,* ... , *TSₖ* which may be sorted in ascending order. These *k* thresholds may segment the real line into *k +* 1 segments. To each of these *k +* 1 segments, different predetermined correction coefficients may be associated which may be stored on the capacitive sensor device. In case the cumulated reference value, or alternatively a filtered cumulated reference value, is found to lie in segment *i*, the current correction coefficients may be set to the predetermined correction coefficients associated to said segment *i*. In case only a first-order drift correction is carried out, for example, to each segment there may be associated one first order correction coefficient. In case a first-order drift correction and a second-order drift correction are carried out, for example, to each segment there may be associated one first order correction coefficient and one second order correction coefficient. Preferentially, the real line into three may be segmented into three segments using two thresholds. The cumulated difference reference value is defined as Δ*RV*⁽⁰⁾(*tₙ*) *= RV*(*tₙ*) *- RV*(*t*₀)*.*

In a further embodiment of the capacitive sensor device according to the invention, the capacitive sensor device is configured to at least temporarily store at least one previously adaptively selected at least one correction coefficient, and the capacitive sensor device is configured to determine at least one updated current correction coefficient by applying a filter to the 1) at least one current correction coefficient and the 2) at least one previously adaptively selected at least one correction coefficient, and wherein the capacitive sensor device is configured to replace the at least one current correction coefficient with the at least one updated current correction coefficient for determining the corrected current main value.

Quick switching between correction coefficients may lead to unwanted steps and noise in the corrected main values. If correction coefficients are, for example, selected based on whether temperature is increasing or decreasing (which may be detected by measuring whether reference values are increasing or decreasing), temperature noise may lead to quick successions of correction coefficient switches. The correction coefficients may be smoothed to reduce such unwanted steps in the corrected main values. Smoothing or more general filtering may proceed using a FIR filter or an infinite impulse response (IIR) filter. The capacitive sensor device may store previously selected correction coefficients. The at least one current correction coefficient *Cₙ* and the stored previously selected at least one correction coefficients *C*_{*n*-1}, *Cₙ₋₂, ..., Cₙ₋ₚ* (*p* previously selected at least one correction coefficients may be stored) may be filtered with a causal FIR filter, the FIR filtering providing at least one updated current correction coefficient ${{C}_{n}}^{˜}$. The at least one current correction coefficient *Cₙ* and the stored previously selected at least one correction coefficients *C*_{*n*-1}, *C*_{*n*-2}*,* ..., *Cₙ₋ₚ* may also be filtered using an IIR filter: for a general IIR filter, previously selected at least one updated correction coefficients ${{C}_{n - 1}}^{˜} , {{C}_{n - 2}}^{˜} , … , {{C}_{n - q}}^{˜}$ may be stored on the capacitive sensor device; the IIR filter may be embodied as a causal recursive system. For both FIR filter and IIR filter, p may, for example, be embodied as a power of two, for example one of 1, 2, 4, ..., 128. The FIR filter may be embodied as a weighted average filter, or in any other suitable way. The at least one updated current correction coefficient may then be used for removing drift from the main values: in case a first order drift removal is carried out, correction may proceed as $MV * \left({t}_{n}\right) = MV \left({t}_{n}\right) - {{C}_{n}}^{˜} Δ {RV}^{\left(0\right)} \left({t}_{n}\right)$. For combined first order and second order correction, correction coefficients corresponding to different order terms may be filtered separately.

In a further embodiment of the capacitive sensor device according to the invention, the filter is a finite impulse response (FIR) filter, or the filter is a causal recursive infinite impulse response (IIR) filter with finitely many nonzero IIR filter coefficients.

In a further embodiment of the capacitive sensor device according to the invention, the capacitive sensor device is configured to at least temporarily store at least one previously measured main value, and the capacitive sensor device is configured to determine a current difference reference value between the current reference value and a comparison reference value from the at least one previously measured reference value and the capacitive sensor device is configured to determine a current difference main value between the current main value and a comparison main value from the at least one previously measured main value, and the capacitive sensor device is configured to at least temporarily store at least one previously determined difference reference value and at least one previously determined difference main value, wherein the capacitive sensor device is configured to determine a filtered current difference reference value by applying a filter to the current difference reference value and the at least one stored previously determined difference reference value and wherein the capacitive sensor device is configured to determine a filtered current difference main value by applying a filter to the current difference main value and the at least one stored previously determined difference main value, and wherein the capacitive sensor device is configured to adaptively determine a single current correction coefficient based on a ratio of the filtered current difference main value and the filtered current difference reference value, wherein the capacitive sensor device is configured to determine the corrected current main value by subtracting the product of the single current correction coefficient and a cumulated difference reference value from the current main value.

As described above, a filtered current difference reference value ${Δ RV}^{˜} \left({t}_{n}\right)$ may be determined which may correspond to an average trend/slope of the reference values close to the current reference value. Analogously, a filtered current difference main value ${Δ MV}^{˜} \left({t}_{n}\right)$ may be determined which may correspond to an average trend/slope of the main values close to the current main value. The filter used for determining the filtered current difference main value may be the same as the filter used for determining the filtered current difference reference value; alternatively, the two filters may differ from one another. Pre-storing correction coefficients on the capacitive sensor device may not provide optimal environmental drift correction as optimal correction coefficients may vary from one portable electronic device to another into which the capacitive sensor device may be integrated, e.g., due to components/assembly/production tolerance/precision. The single current correction coefficient may therefore be determined online, i.e., in real time, for a capacitive sensor device by dividing the filtered current difference main value with the filtered current difference reference value. The accordingly obtained single current correction coefficient may then be used for first order drift removal from the main values. The determined single current correction coefficient and previously determined single current correction coefficients may also be stored on the capacitive sensor device and filtered to for example further smooth the determined single current correction coefficient, e.g., using a causal FIR filter.

In a further embodiment of the capacitive sensor device according to the invention, the capacitive sensor device is configured to determine the single current correction coefficient by comparing the ratio of the filtered current difference main value and the filtered current difference reference value to a lower threshold and/or to an upper threshold, with the upper threshold being larger than the lower threshold, and wherein the capacitive sensor device is configured to 1) set the single current correction coefficient to the lower threshold in case the ratio is smaller than the lower threshold, 2) set the single current correction coefficient to the upper threshold in case the ratio is larger than the upper threshold, and 3) otherwise set the single current correction coefficient to the ratio.

The lower threshold and the upper threshold may be pre-stored on the capacitive sensor device. An approaching/receding conductive body may rapidly change the capacitance seen by the main sense input, leading to a quickly increasing/decreasing current main value. The ratio between the filtered current difference main value and the filtered current difference reference value may in that case quickly increase/decrease, thereby providing a rapidly changing single correction coefficient. To avoid such rapid correction coefficient changes, the single current correction coefficient may be clamped. In case the ratio is smaller than the lower threshold, the value of the single correction coefficient may be set to the lower threshold, and in case the ratio is larger than the upper threshold, the value of the single correction coefficient may be set to the upper threshold. If, for example, based on a typical characterization process it is found that a typical value of the single correction coefficient is 4.5, the lower threshold may be set to four and the upper threshold may be set to five.

In the capacitive sensor device according to the invention, the main sense input is coupled with a capacitive sense electrode whose self-capacitance changes at an approach of a conductive body and the reference sense input is coupled with a discrete reference capacitor of the device.

In a further embodiment of the capacitive sensor device according to the invention, the capacitive sense electrode is embodied as a conductor area on a printed circuit board, and/or the capacitive sensor device internally comprises the capacitive reference electrode, and the capacitance of the capacitive reference electrode is less affected by the approach of the conductive body than the capacitance of the capacitive sense electrode.

The capacitive sense electrode may also be embodied as an antenna. The discrete reference capacitor may preferentially be placed close to the antenna to catch similar environmental drift as the antenna. The capacitive reference electrode may be suitably designed in such a way that approaching/receding conductive bodies have only a small/insignificant impact on the measured capacitance of the capacitive reference electrode. The capacitive sensor device may also be provided on the printed circuit board. The capacitive reference electrode may be realized on the same printed circuit board or internally to the capacitive sensor device, for example as a capacitive pad which is not bonded out, or as the analogue-digital converter's mux/floating input. Alternatively, the reference values may also be obtained by other means than capacitive measurements: for example, a temperature sensor using PTAT (proportional to absolute temperature) may be integrated on the printed circuit board on which the capacitive sensor device is placed or internally to the capacitive sensor device.

According to the present invention, there is provided a portable electronic device comprising a capacitive sensor device according to the first aspect of the present invention, wherein the capacitive sensor device is configured to generate a proximity signal based on the corrected current main value, and wherein the portable electronic device is configured to activate a predetermined action when the proximity signal is generated and/or when the proximity signal is extinguished.

The portable electronic device may be embodied as a mobile phone or as a tablet, for example. The generated proximity signal may indicate that a conductive body, e.g., a human body, is close to the portable electronic device. Based on such information, the portable electronic device may for example reduce output power for communications in order to reduce radiation doses absorbed by a human close to the portable electronic device.

In an embodiment of the portable electronic device according to the further aspect of the present invention, the predetermined action is one of: change a power of a radio transmitter, switch on or off a display backlight, enable or disable a tactile input interface.

### Brief description of drawings

Exemplar embodiments of the invention are disclosed in the description and illustrated by the drawings in which:
Fig. 1 schematically illustrates a capacitive sensor device according to the invention with a separate capacitive sense electrode and a separate capacitive reference electrode;
Fig. 2 schematically illustrates temperature drift compensation in a capacitive sensor device as known from the prior art; and
Fig. 3 schematically illustrates the need for adapting correction coefficients over time as carried out in a capacitive sensor device according to the invention.

### Detailed description of drawings

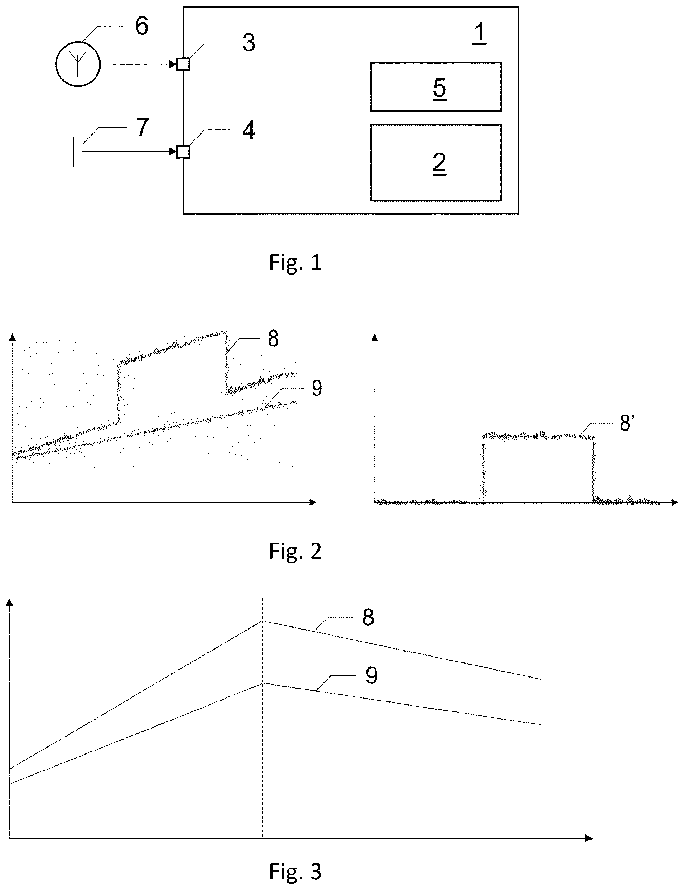

**Fig. 1** schematically illustrates a capacitive sensor device 1 according to the invention with a separate capacitive sense electrode 6 and a separate capacitive reference electrode 7. The capacitive sensor device 1 comprises a capacitance-measuring circuit 2, a main sense input 3, a reference sense input 4 and a suitable memory 5, e.g., embodied as a buffer or as more general memory. The capacitance-measuring circuit 2 is configured to measure a current main value of capacitance seen by the main sense input 3 and a current reference value of capacitance seen by the reference sense input 4.

As shown in Fig. 1, the capacitance seen by the main sense input 3 may be the self-capacitance of a separate sensor 6, the separate capacitive sense electrode 6, which is detached from the capacitive sensor device 1. The capacitive sense electrode 6 may be embodied as an antenna which may be jointly used by a transceiver of a portable electronic device, which transceiver is used for communication purposes by the portable electronic device, and in which portable electronic device the capacitive sensor device 1 may be integrated. The capacitive sense electrode 6 may also be embodied as a standalone capacitive pad. The capacitive sense electrode 6 may be embodied as a conductor area on a printed circuit board. The capacitive sense electrode 6 may be embodied in such a way that its self-capacitance changes at an approach of a conductive body, e.g., a human body. The capacitance-measuring circuit 2 may detect tiny variations attributable to the approach of the conductive body.

As further shown in Fig. 1, the capacitance seen by the reference sense input 4 may be the capacitance of a separate sensor 7, specifically of a discrete capacitor 7 as shown in Fig. 1.

The capacitive reference electrode is preferentially embodied/placed in such a way that its capacitance is substantially unaffected by approaching or receding conductive bodies and is substantially only sensitive to environmental drift, in particular drift due to changing temperature in the environment of the capacitive sensor device 1. In contrast, the capacitive sense electrode 6 is sensitive to both environmental drift and to capacitance changes due to approaching/receding conductive bodies. The capacitance seen by the reference sense input 4 may also be the capacitance of a connection pin at the reference sense input 4: in this case, no separate capacitive reference electrode 7 may be needed.

Fig. 2 schematically illustrates temperature drift compensation in a capacitive sensor device as known from the prior art. In the sub-figure of Fig. 2 on the left, measured capacitance values 8 (depicted together with an additional noisy component), termed main values, of capacitance seen by the main sense input 3 over a period of time and measured capacitance values 9, termed reference values, of capacitance seen by the reference sense input 4 over the same period of time are shown. The x-axis denotes time in both sub-figures of Fig. 2. In the sub-figure of Fig. 2 on the left, environmental temperature increases over time, leading to a drift in both measured main values 8 and reference values 9. In the main values 8 shown in Fig. 2, there is an additional jump in the measured main values 8. This jump indicates the (sudden) presence of a conductive body, which inductive body increases the measured capacitance. For the capacitive sensor device to be able to detect the (sudden) presence of a conductive body indicated by the jump in Fig. 2, it is helpful to remove the drift in the measured main values 8. To remove this temperature drift from the measured main values 8, in the prior art it is assumed that the temperature drift in the main values 8 is the same as or proportional to the temperature drift in the reference values 9.

In the prior art, temperature drift removal is typically carried out as follows. At a sampling time tₙ, a corrected main value *MV**(*tₙ*) is determined based on a linear correction *MV**(*tₙ*) *= MV*(*tₙ*) *- C ·* Δ*RV*⁽⁰⁾(*tₙ*), with *MV*(*tₙ*) being the measured main value at time *tₙ*, *C* a (correction) coefficient, Δ*RV*⁽⁰⁾(*tₙ*) *= RV*(*tₙ*) *- RV*(*t*₀) and *RV*(*tₙ*) being the measured reference value at time *tₙ* and *RV*(*t*₀) being the measured reference value at an initial sampling time *t*₀. Δ*RV*⁽⁰⁾(*tₙ*) therefore measures a direction in the reference values with respect to the reference value at the initial sampling time. In the prior art, coefficient *C* is obtained using a calibration process and stored on the capacitive sensor device; once calibrated, *C* is not adapted during runtime. Calibration to determine a value for *C* is in the prior art typically carried out when no conductive body is close to the capacitive sensor device. Temperature drift removal as carried out in the prior art is typically done in real time and for each new sample of the main value. The sub-figure of Fig. 2 on the right shows the corrected main values 8', with temperature drift removed as known from the prior art and previously described.

Fig. 3 schematically illustrates the need for adapting correction coefficients over time as carried out in a capacitive sensor device according to the invention. In Fig. 3, the x-axis represents time, while the y-axis represents capacitance values. The central vertical dashed line in Fig. 3 separates a first region to its left in which environmental temperature is rising from a second region to its right in which environmental temperature is falling. Main values 8 of capacitance seen by the main sense input 3 may rise with increasing temperature and may fall with decreasing temperature, and reference values 9 of capacitance seen by the reference sense input 4 may also rise with increasing temperature and may fall with decreasing temperature, but the proportionality factors between the main values 8 and the reference values 9 may differ between rising temperatures and falling temperatures. In an embodiment of the capacitive sensor device 1 according to the invention, based on the reference values it is determined whether environmental temperature is rising or falling, and if 1) rising, a coefficient for rising temperature conditions may be used for temperature drift removal from the measured main values 8, and if 2) falling, a coefficient for falling temperature conditions may be used for temperature drift removal from the measured main values 8. The example shown in Fig. 3 is only illustrative; in realistic conditions, for example, rising and falling temperatures may arbitrarily vary over time. Other strategies of adapting correction coefficients are disclosed in the embodiments of the capacitive sensor device 1 according to the invention.

### Reference signs appearing in the drawings

- 1: capacitive sensor device
- 2: capacitance-measuring circuit
- 3: main sense input
- 4: reference sense input
- 5: memory
- 6: capacitive sense electrode
- 7: separate sensor
- 8: measured values
- 8': corrected main values
- 9: reference values

## Claims

1. Portable electronic device including a capacitive sensor device (1) comprising a capacitance-measuring circuit (2), a main sense input (3) and a reference sense input (4), wherein the capacitive sensor device (1) is configured to measure, using the capacitance-measuring circuit (2), a current main value of capacitance (8) seen by the main sense input (3) and a current reference value of capacitance (9) seen by the reference sense input (4), wherein the capacitive sensor device (1) is configured to at least temporarily store at least one previously measured reference value, and wherein the capacitive sensor device is configured to use
• the current main value,
• the current reference value and the at least one previously measured reference value, and
• at least one current correction coefficient, with the capacitive sensor device being configured to adaptively determine the at least one current correction coefficient based on at least the current reference value and the at least one previously measured reference value, for determining a corrected current main value (8') of capacitance, wherein the main sense input is coupled with a capacitive sense electrode of the portable electronic device whose self-capacitance changes at an approach of a conductive body, **characterised in that** the reference sense input is connected to a discrete reference capacitor of the device.

2. Portable electronic device according to claim 1, wherein the capacitive sensor device is configured to adaptively determine the at least one current correction coefficient by adaptively selecting, based on a selection criterion based on the current reference value and the at least one previously measured reference value, the at least one current correction coefficient from at least two predetermined correction coefficients, and wherein the selection criterion comprises a comparison to at least one threshold.

3. Portable electronic device according to claim 2, wherein the capacitive sensor device is configured to determine a current difference reference value between the current reference value and a comparison reference value from the at least one previously measured reference value, and wherein the comparison comprises comparing the current difference reference value to the at least one threshold.

4. Portable electronic device according to claim 3, wherein the at least two predetermined correction coefficients comprise a first first order correction coefficient and a second first order correction coefficient which differ from one another and wherein a single current correction coefficient is adaptively selected from the first first order correction coefficient and the second first order correction coefficient, wherein the at least one threshold comprises a single threshold, and wherein the capacitive sensor device is configured to determine whether the current difference reference value is larger or smaller than the single threshold, wherein for a larger current difference reference value the first first order correction coefficient is selected as the single current correction coefficient and for a smaller current difference reference value the second first order correction coefficient is selected as the single current correction coefficient, and wherein the capacitive sensor device is configured to determine the corrected current main value by subtracting the product of the single current correction coefficient and a cumulated difference reference value from the current main value, the cumulated difference being defined as Δ*RV*⁽⁰⁾(*tₙ*) *= RV*(*tₙ*) *- RV*(*t*₀)*, RV*(*tₙ*) denoting the reference value at a current sampling time *tₙ* and *RV*(*t*₀) a first acquired capacitance measurement at a first sampling time *t*₀.

5. Portable electronic device according to claim 3, wherein the at least two predetermined correction coefficients comprise a first first order correction coefficient and a second first order correction coefficient which differ from one another and wherein a single current correction coefficient is adaptively selected from the first first order correction coefficient and the second first order correction coefficient, wherein the capacitive sensor device is configured to at least temporarily store at least one previously determined difference reference value, and wherein the capacitive sensor device is configured to determine a filtered current difference reference value by applying a filter to the current difference reference value and the at least one stored previously determined difference reference value, wherein the at least one threshold comprises a single threshold, and wherein the capacitive sensor device is configured to determine whether the filtered current difference reference value is larger or smaller than the single threshold, wherein for a larger filtered current difference reference value the first first order correction coefficient is selected as the single current correction coefficient and for a smaller current difference reference value the second first order correction coefficient is selected as the single current correction coefficient, and wherein the capacitive sensor device is configured to determine the corrected current main value by subtracting the product of the single current correction coefficient and a cumulated difference reference value from the current main value, the cumulated difference being defined as Δ*RV*⁽⁰⁾(*tₙ*) *= RV*(*tₙ*) *- RV*(*t*₀)*, RV*(*tₙ*) denoting the reference value at a current sampling time *tₙ* and *RV*(*t*₀) a first acquired capacitance measurement at a first sampling time *t₀,* wherein the filter is a finite impulse response (FIR) filter, or wherein the filter is a causal recursive infinite impulse response (IIR) filter with finitely many nonzero IIR filter coefficients.

6. Portable electronic device according to claim 3, wherein the at least two predetermined correction coefficients comprise a first first order correction coefficient, a second first order correction coefficient, a first second order correction coefficient and a second second order correction coefficient, wherein two current correction coefficients are adaptively selected from these four predetermined correction coefficients, wherein the at least one threshold comprises a single threshold, and wherein the capacitive sensor device is configured to determine whether the current difference reference value is larger or smaller than the single threshold, wherein for a larger current difference reference value the first first order correction coefficient is selected as a first current correction coefficient of the two current correction coefficients and the first second order correction coefficient is selected as a second current correction coefficient of the two current correction coefficients, and wherein for a smaller current difference reference value the second first order correction coefficient is selected as a first current correction coefficient of the two current correction coefficients and the second second order correction coefficient is selected as a second current correction coefficient of the two current correction coefficients, and wherein the capacitive sensor device is configured to determine the corrected current main value by subtracting the product of the first current correction coefficient and a cumulated difference reference value and the product of the second current correction coefficient with the square of the cumulated difference reference value from the current main value, the cumulated difference being defined as Δ*RV*⁽⁰⁾(*tₙ*) *= RV*(*tₙ*) *- RV*(*t*₀)*, RV*(*tₙ*) denoting the reference value at a current sampling time *tₙ*, and *RV*(*t*₀) *a* first acquired capacitance measurement at a first sampling time *t*₀.

7. Portable electronic device according to claim 2, wherein the at least one threshold comprises a first threshold and a second threshold, wherein the first threshold is smaller than the second threshold, and wherein the at least two predetermined correction coefficients comprise a first correction coefficient, a second correction coefficient and a third correction coefficient, wherein a single current correction coefficient is adaptively selected from these three predetermined correction coefficients, and wherein the capacitive sensor device is configured to select 1) the first correction coefficient as the single current correction coefficient if a cumulated difference reference value is smaller than the first threshold, 2) the second correction coefficient as the single current correction coefficient if the cumulated difference reference value is larger than or equal to the first threshold and smaller than or equal to the second threshold, and 3) the third correction coefficient as the single current correction coefficient if the cumulated difference reference value is larger than the second threshold, and wherein the capacitive sensor device is configured to determine the corrected current main value by subtracting the product of the single current correction coefficient and the cumulated difference reference value from the current main value, the cumulated difference being defined as Δ*RV*⁽⁰⁾(*tₙ*) *= RV*(*tₙ*) *- RV*(*t*₀)*, RV*(*tₙ*) denoting the reference value at a current sampling time *tₙ*, and *RV*(*t*₀) a first acquired capacitance measurement at a first sampling time *t*₀.

8. Portable electronic device according to any one of claims 2 to 7, wherein the capacitive sensor device is configured to at least temporarily store at least one previously adaptively selected at least one correction coefficient, and wherein the capacitive sensor device is configured to determine at least one updated current correction coefficient by applying a filter to the 1) at least one current correction coefficient and the 2) at least one previously adaptively selected at least one correction coefficient, and wherein the capacitive sensor device is configured to replace the at least one current correction coefficient with the at least one updated current correction coefficient for determining the corrected current main value, wherein the filter is a finite impulse response (FIR) filter, or wherein the filter is a causal recursive infinite impulse response (IIR) filter with finitely many nonzero IIR filter coefficients.

9. Portable electronic device according to claim 1, wherein the capacitive sensor device is configured to at least temporarily store at least one previously measured main value, and wherein the capacitive sensor device is configured to determine a current difference reference value between the current reference value and a comparison reference value from the at least one previously measured reference value and wherein the capacitive sensor device is configured to determine a current difference main value between the current main value and a comparison main value from the at least one previously measured main value, and wherein the capacitive sensor device is configured to at least temporarily store at least one previously determined difference reference value and at least one previously determined difference main value, wherein the capacitive sensor device is configured to determine a filtered current difference reference value by applying a filter to the current difference reference value and the at least one stored previously determined difference reference value and wherein the capacitive sensor device is configured to determine a filtered current difference main value by applying a filter to the current difference main value and the at least one stored previously determined difference main value, and wherein the capacitive sensor device is configured to adaptively determine a single current correction coefficient based on a ratio of the filtered current difference main value and the filtered current difference reference value, wherein the capacitive sensor device is configured to determine the corrected current main value by subtracting the product of the single current correction coefficient and a cumulated difference reference value from the current main value, the cumulated difference being defined as Δ*RV*⁽⁰⁾(*tₙ*) *= RV*(*tₙ*) *- RV*(*t*₀)*, RV*(*tₙ*) denoting the reference value at a current sampling time *tₙ*, and *RV*(*t*₀) a first acquired capacitance measurement at a first sampling time *t₀,* wherein the filter is a finite impulse response (FIR) filter, or wherein the filter is a causal recursive infinite impulse response (IIR) filter with finitely many nonzero IIR filter coefficients.

10. Portable electronic device according to the preceding claim, wherein the capacitive sensor device is configured to determine the single current correction coefficient by comparing the ratio of the filtered current difference main value and the filtered current difference reference value to a lower threshold and/or to an upper threshold, with the upper threshold being larger than the lower threshold, and wherein the capacitive sensor device is configured to 1) set the single current correction coefficient to the lower threshold in case the ratio is smaller than the lower threshold, 2) set the single current correction coefficient to the upper threshold in case the ratio is larger than the upper threshold, and 3) otherwise set the single current correction coefficient to the ratio.

11. Portable electronic device according to claim 1, wherein the capacitive sense electrode is embodied as a conductor area on a printed circuit board, and/or wherein the capacitive reference electrode comprises tracks and/or conductor area on the printed circuit board or wherein the capacitive reference electrode is embodied as a discrete reference capacitor, and/or wherein the capacitive sensor device internally comprises the capacitive reference electrode, and wherein the capacitance of the capacitive reference electrode is less affected by the approach of the conductive body than the capacitance of the capacitive sense electrode.

12. Portable electronic device according to any one of the preceding claims, wherein the capacitive sensor device is configured to generate a proximity signal based on the corrected current main value, and wherein the portable electronic device is configured to activate a predetermined action when the proximity signal is generated and/or when the proximity signal is extinguished.

13. Portable electronic device according to the preceding claim, wherein the predetermined action is one of: change a power of a radio transmitter, switch on or off a display backlight, enable or disable a tactile input interface.

## Patentansprüche

1. Tragbares elektronisches Gerät mit einer kapazitiven Sensorvorrichtung (1), welche eine Kapazitätsmessschaltung (2), einen Hauptdetektionseingang (3) und einen Referenzdetektionseingang (4) umfasst, worin die kapazitive Sensorvorrichtung (1) dafür konfiguriert ist, unter Verwendung der Kapazitätsmessschaltung (2) einen aktuellen Hauptkapazitätswert (8), der am Hauptdetektionseingang (3) anliegt, und einen aktuellen Referenzkapazitätswert (9), der am Referenzdetektionseingang (4) anliegt, zu messen, worin die kapazitive Sensorvorrichtung (1) dafür konfiguriert ist, mindestens einen zuvor gemessenen Referenzwert zumindest vorübergehend zu speichern, und worin die kapazitive Sensorvorrichtung dafür konfiguriert ist,
- den aktuellen Hauptwert,
- den aktuellen Referenzwert und den mindestens einen zuvor gemessenen Referenzwert, und
- mindestens einen aktuellen Korrekturkoeffizienten zu verwenden, wobei die kapazitive Sensorvorrichtung dafür konfiguriert ist, den mindestens einen aktuellen Korrekturkoeffizienten basierend auf mindestens dem aktuellen Referenzwert und dem mindestens einen zuvor gemessenen Referenzwert adaptiv zu bestimmen,
um einen korrigierten aktuellen Hauptkapazitätswert (8') zu bestimmen, worin der Hauptdetektionseingang mit einer kapazitiven Detektionselektrode des tragbaren elektronischen Geräts gekoppelt ist, deren Eigenkapazität sich bei Annäherung eines leitfähigen Körpers ändert, **dadurch gekennzeichnet, dass** der Referenzdetektionseingang mit einem diskreten Referenzkondensator des Geräts verbunden ist.

2. Tragbares elektronisches Gerät gemäss Anspruch 1, wobei die kapazitive Sensorvorrichtung dafür konfiguriert ist, den mindestens einen aktuellen Korrekturkoeffizienten adaptiv zu bestimmen, indem sie basierend auf einem Selektionskriterium, welches auf dem aktuellen Referenzwert und dem mindestens einen zuvor gemessenen Referenzwert basiert, den mindestens einen aktuellen Korrekturkoeffizienten aus mindestens zwei vorbestimmten Korrekturkoeffizienten adaptiv auswählt, und worin das Selektionskriterium einen Vergleich mit mindestens einem Schwellenwert umfasst.

3. Tragbares elektronisches Gerät gemäss Anspruch 2, worin die kapazitive Sensorvorrichtung dafür konfiguriert ist, einen aktuellen Differenz-Referenzwert zwischen dem aktuellen Referenzwert und einem Vergleichs-Referenzwert aus dem mindestens einen zuvor gemessenen Referenzwert zu bestimmen, und worin der Vergleich das Vergleichen des aktuellen Differenz-Referenzwerts mit dem mindestens einen Schwellenwert umfasst.

4. Tragbares elektronisches Gerät gemäss Anspruch 3, worin die mindestens zwei vorbestimmten Korrekturkoeffizienten einen ersten Korrekturkoeffizienten erster Ordnung und einen zweiten Korrekturkoeffizienten erster Ordnung umfassen, welche sich voneinander unterscheiden, und worin ein einzelner aktueller Korrekturkoeffizient adaptiv aus dem ersten Korrekturkoeffizienten erster Ordnung und dem zweiten Korrekturkoeffizienten erster Ordnung ausgewählt wird, worin der mindestens eine Schwellenwert einen einzelnen Schwellenwert umfasst, und worin die kapazitive Sensorvorrichtung dafür konfiguriert ist zu bestimmen, ob der aktuelle Differenz-Referenzwert grösser oder kleiner als der einzelne Schwellenwert ist, worin für einen grösseren aktuellen Differenz-Referenzwert der erste Korrekturkoeffizient erster Ordnung als einzelner aktueller Korrekturkoeffizient ausgewählt wird und für einen kleineren aktuellen Differenz-Referenzwert der zweite Korrekturkoeffizient erster Ordnung als einzelner aktueller Korrekturkoeffizient ausgewählt wird, und worin die kapazitive Sensorvorrichtung dafür konfiguriert ist, den korrigierten aktuellen Hauptwert zu bestimmen durch Subtrahieren des Produkts aus dem einzelnen aktuellen Korrekturkoeffizienten und einem kumulierten Differenz-Referenzwert vom aktuellen Hauptwert, wobei die kumulierte Differenz definiert ist als Δ*RV*⁽⁰⁾(*tₙ*) *= RV*(*tₙ*) - *RV*(*t*₀), wobei *RV*(*tₙ*) en Referenzwert zu einem aktuellen Abtastzeitpunkt *tₙ* bezeichnet und *RV*(*t*₀) eine erste erfasste Kapazitätsmessung zu einem ersten Abtastzeitpunkt *t₀*.

5. Tragbares elektronisches Gerät gemäss Anspruch 3, worin die mindestens zwei vorbestimmten Korrekturkoeffizienten einen ersten Korrekturkoeffizienten erster Ordnung und einen zweiten Korrekturkoeffizienten erster Ordnung umfassen, welche sich voneinander unterscheiden, und worin ein einzelner aktueller Korrekturkoeffizient adaptiv aus dem ersten Korrekturkoeffizienten erster Ordnung und dem zweiten Korrekturkoeffizienten erster Ordnung ausgewählt wird, worin die kapazitive Sensorvorrichtung dafür konfiguriert ist, mindestens einen zuvor bestimmten Differenz-Referenzwert zumindest vorübergehend zu speichern, und worin die kapazitive Sensorvorrichtung dafür konfiguriert ist, einen gefilterten aktuellen Differenz-Referenzwert durch Anwenden eines Filters auf den aktuellen Differenz-Referenzwert und den mindestens einen gespeicherten zuvor bestimmten Differenz-Referenzwert zu bestimmen, worin der mindestens eine Schwellenwert einen einzelnen Schwellenwert umfasst, und worin die kapazitive Sensorvorrichtung dafür konfiguriert ist zu bestimmen, ob der gefilterte aktuelle Differenz-Referenzwert grösser oder kleiner als der einzelne Schwellenwert ist, worin für einen grösseren gefilterten aktuellen Differenz-Referenzwert der erste Korrekturkoeffizient erster Ordnung als einzelner aktueller Korrekturkoeffizient ausgewählt wird und für einen kleineren gefilterten aktuellen Differenz-Referenzwert der zweite Korrekturkoeffizient erster Ordnung als einzelner aktueller Korrekturkoeffizient ausgewählt wird, und worin die kapazitive Sensorvorrichtung dafür konfiguriert ist, den korrigierten aktuellen Hauptwert zu bestimmen durch Subtrahieren des Produkts aus dem einzelnen aktuellen Korrekturkoeffizienten und einem kumulierten Differenz-Referenzwert vom aktuellen Hauptwert, wobei die kumulierte Differenz definiert ist als Δ*RV*⁽⁰⁾(*tₙ*) *= RV*(*tₙ*) - *RV*(*t*₀), wobei *RV*(*tₙ*) den Referenzwert zu einem aktuellen Abtastzeit-punkt *tₙ* bezeichnet und *RV*(*t*₀) eine erste erfasste Kapazitätsmessung zu einem ersten Abtastzeitpunkt *t₀*, worin das Filter ein Filter mit endlicher Impulsantwort (FIR) ist, oder worin das Filter ein kausales rekursives Filter mit unendlicher Impulsantwort (IIR) mit endlich vielen IIR-Filterkoeffizienten ungleich Null ist.

6. Tragbares elektronisches Gerät gemäss Anspruch 3, worin die mindestens zwei vorbestimmten Korrekturkoeffizienten einen ersten Korrekturkoeffizienten erster Ordnung, einen zweiten Korrekturkoeffizienten erster Ordnung, einen ersten Korrekturkoeffizienten zweiter Ordnung und einen zweiten Korrekturkoeffizienten zweiter Ordnung umfassen, worin zwei aktuelle Korrekturkoeffizienten adaptiv aus diesen vier vorbestimmten Korrekturkoeffizienten ausgewählt werden, worin der mindestens eine Schwellenwert einen einzelnen Schwellenwert umfasst, und worin die kapazitive Sensorvorrichtung dafür konfiguriert ist zu bestimmen, ob der aktuelle Differenz-Referenzwert grösser oder kleiner als der einzelne Schwellenwert ist, worin für einen grösseren aktuellen Differenz-Referenzwert der erste Korrekturkoeffizient erster Ordnung als ein erster aktueller Korrekturkoeffizient der zwei aktuellen Korrekturkoeffizienten ausgewählt wird und der erste Korrekturkoeffizient zweiter Ordnung als ein zweiter aktueller Korrekturkoeffizient der zwei aktuellen Korrekturkoeffizienten ausgewählt wird, und worin für einen kleineren aktuellen Differenz-Referenzwert der zweite Korrekturkoeffizient erster Ordnung als ein erster aktueller Korrekturkoeffizient der zwei aktuellen Korrekturkoeffizienten ausgewählt wird und der zweite Korrekturkoeffizient zweiter Ordnung als ein zweiter aktueller Korrekturkoeffizient der zwei aktuellen Korrekturkoeffizienten ausgewählt wird, und worin die kapazitive Sensorvorrichtung dafür konfiguriert ist, den korrigierten aktuellen Hauptwert zu bestimmen durch Subtrahieren des Produkts aus dem ersten aktuellen Korrekturkoeffizienten und einem kumulierten Differenz-Referenzwert sowie des Produkts aus dem zweiten aktuellen Korrekturkoeffizienten mit dem Quadrat des kumulierten Differenz-Referenzwerts vom aktuellen Hauptwert, wobei die kumulierte Differenz definiert ist als Δ*RV*⁽⁰⁾(*tₙ*) *= RV*(*tₙ*) - *RV*(*t*₀), wobei *RV*(*tₙ*) den Referenzwert zu einem aktuellen Abtastzeitpunkt *tₙ* bezeichnet und *RV*(*t*₀) eine erste erfasste Kapazitätsmessung zu einem ersten Abtastzeitpunkt *t₀*.

7. Tragbares elektronisches Gerät gemäss Anspruch 2, worin der mindestens eine Schwellenwert einen ersten Schwellenwert und einen zweiten Schwellenwert umfasst, worin der erste Schwellenwert kleiner ist als der zweite Schwellenwert, und worin die mindestens zwei vorbestimmten Korrekturkoeffizienten einen ersten Korrekturkoeffizienten, einen zweiten Korrekturkoeffizienten und einen dritten Korrekturkoeffizienten umfassen, worin ein einzelner aktueller Korrekturkoeffizient adaptiv aus diesen drei vorbestimmten Korrekturkoeffizienten ausgewählt wird, und worin die kapazitive Sensorvorrichtung dafür konfiguriert ist auszuwählen: 1) den ersten Korrekturkoeffizienten als den einzelnen aktuellen Korrekturkoeffizienten, wenn ein kumulierter Differenz-Referenzwert kleiner ist als der erste Schwellenwert, 2) den zweiten Korrekturkoeffizienten als den einzelnen aktuellen Korrekturkoeffizienten, wenn der kumulierte Differenz-Referenzwert grösser oder gleich dem ersten Schwellenwert und kleiner oder gleich dem zweiten Schwellenwert ist, und 3) den dritten Korrekturkoeffizienten als den einzelnen aktuellen Korrekturkoeffizienten, wenn der kumulierte Differenz-Referenzwert grösser ist als der zweite Schwellenwert, und worin die kapazitive Sensorvorrichtung dafür konfiguriert ist, den korrigierten aktuellen Hauptwert zu bestimmen durch Subtrahieren des Produkts aus dem einzelnen aktuellen Korrekturkoeffizienten und dem kumulierten Differenz-Referenzwert vom aktuellen Hauptwert, wobei die kumulierte Differenz definiert ist als Δ*RV*⁽⁰⁾(*tₙ*) *= RV*(*tₙ*) - *RV*(*t*₀), wobei *RV*(*tₙ*) den Referenzwert zu einem aktuellen Abtastzeitpunkt *tₙ* bezeichnet und *RV*(*t*₀) eine erste erfasste Kapazitätsmessung zu einem ersten Abtastzeitpunkt *t₀*.

8. Tragbares elektronisches Gerät gemäss einem der Ansprüche 2 bis 7, worin die kapazitive Sensorvorrichtung dafür konfiguriert ist, mindestens einen zuvor adaptiv ausgewählten mindestens einen Korrekturkoeffizienten zumindest vorübergehend zu speichern, und worin die kapazitive Sensorvorrichtung dafür konfiguriert ist, mindestens einen aktualisierten aktuellen Korrekturkoeffizienten durch Anwenden eines Filters auf 1) den mindestens einen aktuellen Korrekturkoeffizienten und 2) den mindestens einen zuvor adaptiv ausgewählten mindestens einen Korrekturkoeffizienten zu bestimmen, und worin die kapazitive Sensorvorrichtung dafür konfiguriert ist, den mindestens einen aktuellen Korrekturkoeffizienten durch den mindestens einen aktualisierten aktuellen Korrekturkoeffizienten zu ersetzen, um den korrigierten aktuellen Hauptwert zu bestimmen, worin das Filter ein Filter mit endlicher Impulsantwort (FIR) ist, oder worin das Filter ein kausales rekursives Filter mit unendlicher Impulsantwort (IIR) mit endlich vielen IIR-Filterkoeffizienten ungleich Null ist.

9. Tragbares elektronisches Gerät gemäss Anspruch 1, worin die kapazitive Sensorvorrichtung dafür konfiguriert ist, mindestens einen zuvor gemessenen Hauptwert zumindest vorübergehend zu speichern, und wobei die kapazitive Sensorvorrichtung dafür konfiguriert ist, einen aktuellen Differenz-Referenzwert zwischen dem aktuellen Referenzwert und einem Vergleichs-Referenzwert aus dem mindestens einen zuvor gemessenen Referenzwert zu bestimmen, und worin die kapazitive Sensorvorrichtung dafür konfiguriert ist, einen aktuellen Differenz-Hauptwert zwischen dem aktuellen Hauptwert und einem Vergleichs-Hauptwert aus dem mindestens einen zuvor gemessenen Hauptwert zu bestimmen, und worin die kapazitive Sensorvorrichtung dafür konfiguriert ist, mindestens einen zuvor bestimmten Differenz-Referenzwert und mindestens einen zuvor bestimmten Differenz-Hauptwert zumindest vorübergehend zu speichern, worin die kapazitive Sensorvorrichtung dafür konfiguriert ist, einen gefilterten aktuellen Differenz-Referenzwert durch Anwenden eines Filters auf den aktuellen Differenz-Referenzwert und den mindestens einen gespeicherten zuvor bestimmten Differenz-Referenzwert zu bestimmen, und worin die kapazitive Sensorvorrichtung dafür konfiguriert ist, einen gefilterten aktuellen Differenz-Hauptwert durch Anwenden eines Filters auf den aktuellen Differenz-Hauptwert und den mindestens einen gespeicherten zuvor bestimmten Differenz-Hauptwert zu bestimmen, und worin die kapazitive Sensorvorrichtung dafür konfiguriert ist, einen einzelnen aktuellen Korrekturkoeffizienten basierend auf einem Verhältnis des gefilterten aktuellen Differenz-Hauptwerts und des gefilterten aktuellen Differenz-Referenzwerts adaptiv zu bestimmen, worin die kapazitive Sensorvorrichtung dafür konfiguriert ist, den korrigierten aktuellen Hauptwert zu bestimmen durch Subtrahieren des Produkts aus dem einzelnen aktuellen Korrekturkoeffizienten und einem kumulierten Differenz-Referenzwert vom aktuellen Hauptwert, wobei die kumulierte Differenz definiert ist als Δ*RV*⁽⁰⁾(*tₙ*) *= RV*(*tₙ*) - *RV*(*t*₀), wobei *RV*(*tₙ*) den Referenzwert zu einem aktuellen Abtastzeitpunkt *tₙ* bezeichnet und *RV*(*t*₀) eine erste erfasste Kapazitätsmessung zu einem ersten Abtastzeitpunkt *t₀*, worin das Filter ein Filter mit endlicher Impulsantwort (FIR) ist, oder worin das Filter ein kausales rekursives Filter mit unendlicher Impulsantwort (IIR) mit endlich vielen IIR-Filterkoeffizienten ungleich Null ist.

10. Tragbares elektronisches Gerät gemäss dem vorhergehenden Anspruch, worin die kapazitive Sensorvorrichtung dafür konfiguriert ist, den einzelnen aktuellen Korrekturkoeffizienten zu bestimmen durch Vergleichen des Verhältnisses des gefilterten aktuellen Differenz-Hauptwerts und des gefilterten aktuellen Differenz-Referenzwerts mit einem unteren Schwellenwert und/oder einem oberen Schwellenwert, worin der obere Schwellenwert grösser ist als der untere Schwellenwert, und worin die kapazitive Sensorvorrichtung dafür konfiguriert ist, 1) den einzelnen aktuellen Korrekturkoeffizienten auf den unteren Schwellenwert zu setzen, falls das Verhältnis kleiner als der untere Schwellenwert ist, 2) den einzelnen aktuellen Korrekturkoeffizienten auf den oberen Schwellenwert zu setzen, falls das Verhältnis grösser als der obere Schwellenwert ist, und 3) andernfalls den einzelnen aktuellen Korrekturkoeffizienten auf das Verhältnis zu setzen.

11. Tragbares elektronisches Gerät gemäss Anspruch 1, worin die kapazitive Detektionselektrode als Leiterfläche auf einer gedruckten Leiterplatte ausgebildet ist, und/oder worin die kapazitive Referenzelektrode Leiterbahnen und/oder eine Leiterfläche auf der gedruckten Leiterplatte umfasst oder worin die kapazitive Referenzelektrode als diskreter Referenzkondensator ausgebildet ist, und/oder worin die kapazitive Sensorvorrichtung intern die kapazitive Referenzelektrode umfasst, und worin die Kapazität der kapazitiven Referenzelektrode durch die Annäherung des leitfähigen Körpers weniger beeinflusst wird als die Kapazität der kapazitiven Detektionselektrode.

12. Tragbares elektronisches Gerät gemäss irgendeinem der vorhergehenden Ansprüche, worin die kapazitive Sensorvorrichtung dafür konfiguriert ist, basierend auf dem korrigierten aktuellen Hauptwert ein Annäherungssignal zu erzeugen, und worin das tragbare elektronische Gerät dafür konfiguriert ist, eine vorbestimmte Aktion zu aktivieren, wenn das Annäherungssignal erzeugt wird und/oder wenn das Annäherungssignal erlischt.

13. Tragbares elektronisches Gerät gemäss dem vorhergehenden Anspruch, worin die vorbestimmte Aktion eine der folgenden ist: Ändern einer Leistung eines Funksenders, Ein- oder Ausschalten einer Display-Hintergrundbeleuchtung, Aktivieren oder Deaktivieren einer taktilen Eingabeschnittstelle.

## Revendications

1. Dispositif électronique portable incluant un dispositif de capteur capacitif (1) comprenant un circuit de mesure de capacité (2), une entrée de détection principale (3) et une entrée de détection de référence (4), dans lequel le dispositif de capteur capacitif (1) est configuré pour mesurer, au moyen du circuit de mesure de capacité (2), une valeur principale actuelle de capacité (8) vue par l'entrée de détection principale (3) et une valeur de référence actuelle de capacité (9) vue par l'entrée de détection de référence (4), dans lequel le dispositif de capteur capacitif (1) est configuré pour stocker au moins temporairement au moins une valeur de référence mesurée précédemment, et dans lequel le dispositif de capteur capacitif est configuré pour utiliser :
- la valeur principale actuelle,
- la valeur de référence actuelle et l'au moins une valeur de référence mesurée précédemment, et
- au moins un coefficient de correction actuel, le dispositif de capteur capacitif étant configuré pour déterminer de manière adaptative l'au moins un coefficient de correction actuel sur la base d'au moins la valeur de référence actuelle et de l'au moins une valeur de référence mesurée précédemment,
pour déterminer une valeur principale actuelle corrigée (8') de capacité, dans lequel l'entrée de détection principale est couplée à une électrode de détection capacitive du dispositif électronique portable dont la capacité propre varie lors de l'approche d'un corps conducteur, **caractérisé en ce que** l'entrée de détection de référence est connectée à un condensateur de référence discret du dispositif.

2. Dispositif électronique portable selon la revendication 1, dans lequel le dispositif de capteur capacitif est configuré pour déterminer de manière adaptative l'au moins un coefficient de correction actuel en sélectionnant de manière adaptative, sur la base d'un critère de sélection fondé sur la valeur de référence actuelle et l'au moins une valeur de référence mesurée précédemment, l'au moins un coefficient de correction actuel parmi au moins deux coefficients de correction prédéterminés, et dans lequel le critère de sélection comprend une comparaison à au moins un seuil.

3. Dispositif électronique portable selon la revendication 2, dans lequel le dispositif de capteur capacitif est configuré pour déterminer une valeur de référence de différence actuelle entre la valeur de référence actuelle et une valeur de référence de comparaison issue de l'au moins une valeur de référence mesurée précédemment, et dans lequel la comparaison comprend la comparaison de la valeur de référence de différence actuelle à l'au moins un seuil.

4. Dispositif électronique portable selon la revendication 3, dans lequel les au moins deux coefficients de correction prédéterminés comprennent un premier coefficient de correction de premier ordre et un second coefficient de correction de premier ordre qui diffèrent l'un de l'autre, et dans lequel un unique coefficient de correction actuel est sélectionné de manière adaptative entre le premier coefficient de correction de premier ordre et le second coefficient de correction de premier ordre, dans lequel l'au moins un seuil comprend un seuil unique, et dans lequel le dispositif de capteur capacitif est configuré pour déterminer si la valeur de référence de différence actuelle est supérieure ou inférieure au seuil unique, dans lequel, pour une valeur de référence de différence actuelle supérieure, le premier coefficient de correction de premier ordre est sélectionné comme l'unique coefficient de correction actuel et, pour une valeur de référence de différence actuelle inférieure, le second coefficient de correction de premier ordre est sélectionné comme l'unique coefficient de correction actuel, et dans lequel le dispositif de capteur capacitif est configuré pour déterminer la valeur principale actuelle corrigée en soustrayant le produit de l'unique coefficient de correction actuel et d'une valeur de référence de différence cumulée de la valeur principale actuelle, la différence cumulée étant définie comme Δ*RV*⁽⁰⁾(*tₙ*) *= RV*(*tₙ*) - *RV*(*t*₀), avec *RV*(*tₙ*) désignant la valeur de référence à un temps d'échantillonnage actuel *tₙ* et *RV*(*t*₀) une première mesure de capacité acquise à un premier temps d'échantillonnage *t₀*.

5. Dispositif électronique portable selon la revendication 3, dans lequel les au moins deux coefficients de correction prédéterminés comprennent un premier coefficient de correction de premier ordre et un second coefficient de correction de premier ordre qui diffèrent l'un de l'autre, et dans lequel un unique coefficient de correction actuel est sélectionné de manière adaptative entre le premier coefficient de correction de premier ordre et le second coefficient de correction de premier ordre, dans lequel le dispositif de capteur capacitif est configuré pour stocker au moins temporairement au moins une valeur de référence de différence déterminée précédemment, et dans lequel le dispositif de capteur capacitif est configuré pour déterminer une valeur de référence de différence actuelle filtrée en appliquant un filtre à la valeur de référence de différence actuelle et à l'au moins une valeur de référence de différence déterminée précédemment stockée, dans lequel l'au moins un seuil comprend un seuil unique, et dans lequel le dispositif de capteur capacitif est configuré pour déterminer si la valeur de référence de différence actuelle filtrée est supérieure ou inférieure au seuil unique, dans lequel, pour une valeur de référence de différence actuelle filtrée supérieure, le premier coefficient de correction de premier ordre est sélectionné comme l'unique coefficient de correction actuel et, pour une valeur de référence de différence actuelle filtrée inférieure, le second coefficient de correction de premier ordre est sélectionné comme l'unique coefficient de correction actuel, et dans lequel le dispositif de capteur capacitif est configuré pour déterminer la valeur principale actuelle corrigée en soustrayant le produit de l'unique coefficient de correction actuel et d'une valeur de référence de différence cumulée de la valeur principale actuelle, la différence cumulée étant définie comme Δ*RV*⁽⁰⁾(*tₙ*) *= RV*(*tₙ*) - *RV*(*t*₀), avec *RV*(*tₙ*) désignant la valeur de référence à un temps d'échantillonnage actuel *tₙ* et *RV*(*t*₀) une première mesure de capacité acquise à un premier temps d'échantillonnage *t₀,* dans lequel le filtre est un filtre à réponse impulsionnelle finie (RIF), ou dans lequel le filtre est un filtre récursif causal à réponse impulsionnelle infinie (RII) présentant un nombre fini de coefficients de filtre RII non nuls.

6. Dispositif électronique portable selon la revendication 3, dans lequel les au moins deux coefficients de correction prédéterminés comprennent un premier coefficient de correction de premier ordre, un second coefficient de correction de premier ordre, un premier coefficient de correction de second ordre et un second coefficient de correction de second ordre, dans lequel deux coefficients de correction actuels sont sélectionnés de manière adaptative parmi ces quatre coefficients de correction prédéterminés, dans lequel l'au moins un seuil comprend un seuil unique, et dans lequel le dispositif de capteur capacitif est configuré pour déterminer si la valeur de référence de différence actuelle est supérieure ou inférieure au seuil unique, dans lequel, pour une valeur de référence de différence actuelle supérieure, le premier coefficient de correction de premier ordre est sélectionné comme premier coefficient de correction actuel des deux coefficients de correction actuels et le premier coefficient de correction de second ordre est sélectionné comme second coefficient de correction actuel des deux coefficients de correction actuels, et dans lequel, pour une valeur de référence de différence actuelle inférieure, le second coefficient de correction de premier ordre est sélectionné comme premier coefficient de correction actuel des deux coefficients de correction actuels et le second coefficient de correction de second ordre est sélectionné comme second coefficient de correction actuel des deux coefficients de correction actuels, et dans lequel le dispositif de capteur capacitif est configuré pour déterminer la valeur principale actuelle corrigée en soustrayant le produit du premier coefficient de correction actuel et d'une valeur de référence de différence cumulée ainsi que le produit du second coefficient de correction actuel par le carré de la valeur de référence de différence cumulée de la valeur principale actuelle, la différence cumulée étant définie comme Δ*RV*⁽⁰⁾(*tₙ*) *= RV*(*tₙ*) - *RV*(*t*₀), avec *RV*(*tₙ*) désignant la valeur de référence à un temps d'échantillonnage actuel *tₙ*, et *RV*(*t*₀) une première mesure de capacité acquise à un premier temps d'échantillonnage *t₀*.

7. Dispositif électronique portable selon la revendication 2, dans lequel l'au moins un seuil comprend un premier seuil et un second seuil, dans lequel le premier seuil est inférieur au second seuil, et dans lequel les au moins deux coefficients de correction prédéterminés comprennent un premier coefficient de correction, un second coefficient de correction et un troisième coefficient de correction, dans lequel un unique coefficient de correction actuel est sélectionné de manière adaptative parmi ces trois coefficients de correction prédéterminés, et dans lequel le dispositif de capteur capacitif est configuré pour sélectionner 1) le premier coefficient de correction comme l'unique coefficient de correction actuel si une valeur de référence de différence cumulée est inférieure au premier seuil, 2) le second coefficient de correction comme l'unique coefficient de correction actuel si la valeur de référence de différence cumulée est supérieure ou égale au premier seuil et inférieure ou égale au second seuil, et 3) le troisième coefficient de correction comme l'unique coefficient de correction actuel si la valeur de référence de différence cumulée est supérieure au second seuil, et dans lequel le dispositif de capteur capacitif est configuré pour déterminer la valeur principale actuelle corrigée en soustrayant le produit de l'unique coefficient de correction actuel et de la valeur de référence de différence cumulée de la valeur principale actuelle, la différence cumulée étant définie comme Δ*RV*⁽⁰⁾(*tₙ*) *= RV*(*tₙ*) - *RV*(*t*₀), avec *RV*(*tₙ*) désignant la valeur de référence à un temps d'échantillonnage actuel *tₙ*, et *RV*(*t*₀) une première mesure de capacité acquise à un premier temps d'échantillonnage *t₀*.

8. Dispositif électronique portable selon l'une quelconque des revendications 2 à 7, dans lequel le dispositif de capteur capacitif est configuré pour stocker au moins temporairement au moins un coefficient de correction précédemment sélectionné de manière adaptative, et dans lequel le dispositif de capteur capacitif est configuré pour déterminer au moins un coefficient de correction actuel mis à jour en appliquant un filtre à 1) l'au moins un coefficient de correction actuel et 2) l'au moins un coefficient de correction précédemment sélectionné de manière adaptative, et dans lequel le dispositif de capteur capacitif est configuré pour remplacer l'au moins un coefficient de correction actuel par l'au moins un coefficient de correction actuel mis à jour pour déterminer la valeur principale actuelle corrigée, dans lequel le filtre est un filtre à réponse impulsionnelle finie (RIF), ou dans lequel le filtre est un filtre récursif causal à réponse impulsionnelle infinie (RII) présentant un nombre fini de coefficients de filtre RII non nuls.

9. Dispositif électronique portable selon la revendication 1, dans lequel le dispositif de capteur capacitif est configuré pour stocker au moins temporairement au moins une valeur principale mesurée précédemment, et dans lequel le dispositif de capteur capacitif est configuré pour déterminer une valeur de référence de différence actuelle entre la valeur de référence actuelle et une valeur de référence de comparaison issue de l'au moins une valeur de référence mesurée précédemment, et dans lequel le dispositif de capteur capacitif est configuré pour déterminer une valeur principale de différence actuelle entre la valeur principale actuelle et une valeur principale de comparaison issue de l'au moins une valeur principale mesurée précédemment, et dans lequel le dispositif de capteur capacitif est configuré pour stocker au moins temporairement au moins une valeur de référence de différence déterminée précédemment et au moins une valeur principale de différence déterminée précédemment, dans lequel le dispositif de capteur capacitif est configuré pour déterminer une valeur de référence de différence actuelle filtrée en appliquant un filtre à la valeur de référence de différence actuelle et à l'au moins une valeur de référence de différence déterminée précédemment stockée, et dans lequel le dispositif de capteur capacitif est configuré pour déterminer une valeur principale de différence actuelle filtrée en appliquant un filtre à la valeur principale de différence actuelle et à l'au moins une valeur principale de différence déterminée précédemment stockée, et dans lequel le dispositif de capteur capacitif est configuré pour déterminer de manière adaptative un unique coefficient de correction actuel sur la base d'un rapport entre la valeur principale de différence actuelle filtrée et la valeur de référence de différence actuelle filtrée, dans lequel le dispositif de capteur capacitif est configuré pour déterminer la valeur principale actuelle corrigée en soustrayant le produit de l'unique coefficient de correction actuel et d'une valeur de référence de différence cumulée de la valeur principale actuelle, la différence cumulée étant définie comme Δ*RV*⁽⁰⁾(*tₙ*) *= RV*(*tₙ*) - *RV*(*t*₀), avec *RV*(*tₙ*) désignant la valeur de référence à un temps d'échantillonnage actuel *tₙ*, et *RV*(*t*₀) une première mesure de capacité acquise à un premier temps d'échantillonnage *t₀*, dans lequel le filtre est un filtre à réponse impulsionnelle finie (RIF), ou dans lequel le filtre est un filtre récursif causal à réponse impulsionnelle infinie (RII) présentant un nombre fini de coefficients de filtre RII non nuls.

10. Dispositif électronique portable selon la revendication précédente, dans lequel le dispositif de capteur capacitif est configuré pour déterminer l'unique coefficient de correction actuel en comparant le rapport entre la valeur principale de différence actuelle filtrée et la valeur de référence de différence actuelle filtrée à un seuil inférieur et/ou à un seuil supérieur, le seuil supérieur étant plus grand que le seuil inférieur, et dans lequel le dispositif de capteur capacitif est configuré pour 1) définir l'unique coefficient de correction actuel sur le seuil inférieur dans le cas où le rapport est inférieur au seuil inférieur, 2) définir l'unique coefficient de correction actuel sur le seuil supérieur dans le cas où le rapport est supérieur au seuil supérieur, et 3) sinon, définir l'unique coefficient de correction actuel sur la valeur du rapport.

11. Dispositif électronique portable selon la revendication 1, dans lequel l'électrode de détection capacitive est réalisée sous la forme d'une zone conductrice sur une carte de circuit imprimé, et/ou dans lequel l'électrode de référence capacitive comprend des pistes et/ou une zone conductrice sur la carte de circuit imprimé, ou dans lequel l'électrode de référence capacitive est réalisée sous la forme d'un condensateur de référence discret, et/ou dans lequel le dispositif de capteur capacitif comprend de manière interne l'électrode de référence capacitive, et dans lequel la capacité de l'électrode de référence capacitive est moins affectée par l'approche du corps conducteur que la capacité de l'électrode de détection capacitive.

12. Dispositif électronique portable selon l'une quelconque des revendications précédentes, dans lequel le dispositif de capteur capacitif est configuré pour générer un signal de proximité sur la base de la valeur principale actuelle corrigée, et dans lequel le dispositif électronique portable est configuré pour activer une action prédéterminée lorsque le signal de proximité est généré et/ou lorsque le signal de proximité s'éteint.

13. Dispositif électronique portable selon la revendication précédente, dans lequel l'action prédéterminée est l'une parmi : modifier une puissance d'un émetteur radio, allumer ou éteindre un rétroéclairage d'affichage, activer ou désactiver une interface d'entrée tactile.
